(19) Europäisches Patentamt
European Patent Office
Office européen des brevets

(11) Veröffentlichungsnummer : **0 069 292**
**B1**

(12) # EUROPÄISCHE PATENTSCHRIFT

(45) Veröffentlichungstag der Patentschrift : **15.05.85**

(51) Int. Cl.⁴ : **C 08 F 8/00**, H 01 B 1/12, H 01 L 31/02, H 05 F 1/00

(21) Anmeldenummer : **82105599.3**

(22) Anmeldetag : **25.06.82**

(54) **Polymere mit mindestens zwei stabilen und reversibel ineinander umwandelbaren Oxidationsstufen, Verfahren zu ihrer Herstellung und ihre Verwendung.**

(30) Priorität : **03.07.81 DE 3126264**

(43) Veröffentlichungstag der Anmeldung : **12.01.83 Patentblatt 83/02**

(45) Bekanntmachung des Hinweises auf die Patenterteilung : **15.05.85 Patentblatt 85/20**

(84) Benannte Vertragsstaaten : **BE DE FR GB NL**

(56) Entgegenhaltungen :
**DE-A- 1 288 914**
**IBM TECHNICAL DISCLOSURE BULLETIN, Band 22, Nr. 5, Oktober 1979, Seiten 2116-2118, New York (USA); E.M. ENGLER et al.: "Stabilization of film-forming and electrochromic properties of low ionization potential donor polymers"**
**AUSTRALIAN JOURNAL OF CHEMISTRY, Band 28, Nr. 11, November 1975, Seiten 2343-2351; R.C. HADDON: "Quantum chemical studies in the design of organic metals. III Odd-alternant hydrocarbons - the phenalenyl (ply) system"**

(73) Patentinhaber : **BASF Aktiengesellschaft**
**Carl-Bosch-Strasse 38**
**D-6700 Ludwigshafen (DE)**

(72) Erfinder : **Naarmann, Herbert, Dr.**
**Haardtblick 15**
**D-6719 Wattenheim (DE)**
Erfinder : **Penzien, Klaus, Dr.**
**Bensheimer Ring 18**
**D-6710 Frankenthal (DE)**
Erfinder : **Muench, Volker, Dr.**
**Luitpoldstrasse 114**
**D-6700 Ludwigshafen (DE)**
Erfinder : **Franz, Klaus-Dieter, Dr.**
**Industriestrasse 10**
**6233 Kelkheim (DE)**

**EP 0 069 292 B1**

Anmerkung : Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Jouve, 18, rue St-Denis, 75001 Paris, France

**Beschreibung**

Die Erfindung betrifft Polymere mit mindestens zwei stabilen und reversibel ineinander überführbaren Oxidationsstufen mit Halbwertspotentialen im Bereich von $E_{1/2} = -1{,}5$ V bis + 1 V, die hergestellt werden durch Umsetzung von Polymeren mit reaktiven Seitengruppen mit organischen Verbindungen aus der Klasse der 1,9-substituierten Phenalene. Die erfindungsgemäßen Polymeren enthalten dementsprechend als Seitengruppe an der Polymerhauptkette 1,9-disubstituierte Phenalenreste, wobei die Verknüpfung dieser Reste mit der Polymerhauptkette über die 9-Stellung am Phenalenrest erfolgt.

Es ist bereits bekannt, daß sich Polymere mit reaktiven Seitengruppen zu derivatisierten Polymeren mit neuen, wünschenswerten Eigenschaften umsetzen lassen. So reagiert Poly(vinylamin) mit 2-Pyridincarbaldehyd zu einem neuartigen polymeren Chelatbildner für $Cu^{2\oplus}$ (vgl. E. Bayer, K. Geckler und K. Weingärtner, Makromolekulare Chemie, *181*, 585 (1980)). Oder es läßt sich Poly(vinylbenzylchlorid) durch die Derivatisierung mit Tetrathiafulvalen (TTF) in ein elektrochromes Polymeres umwandeln, welches bei Anlegen von Spannung Farbbänderungen aufweist (vgl. F. B. Kaufmann, A. H. Schroeder, E. M. Engler und V. V. Patel, Applied Physical Letters, *36* (6) 422 (1980)).

Es ist weiterhin bekannt, daß der ungeradzahlige, altenierende $C_{13}$-Kohlenwasserstoff Phenalen :

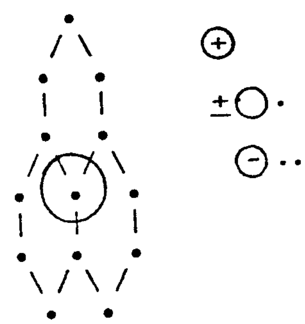

in 3 Oxidationsstufen auftreten kann [vgl. I. Murata, « Topics in Non-Benzoid Aromatic Systems », Vol. I, 159 (1976)]. Bei « Störung » dieses $\pi$-Systems durch 1,9-Substitution bleibt die Fähigkeit des Systems, in mehreren Oxidationsstufen zu existieren, erhalten (vgl. K. D. Franz, Journal of Organic Chemistry, *44*, 1704 (1979) und K. D. Franz und R. L. Martin, Tetrahedron, *34*, 2147 (1978)). So zeigen Phenalene folgende Halbwerts- oder Halbstufenpotentiale ($E_{1/2}$) :

9-Hydroxy-1-phenalenon, $E_{1/2} = -0{,}95$ V
9-Methoxy-1-phenalenon, $E_{1/2} = -1{,}11$ V
9-(N-Methylamino)-1-phenalenon, $E_{1/2} = -1{,}27$ V
1-Ethoxy-9-(benzylthio)-phenaleniumtetrafluorborat, $E_{1/2} = +0{,}1$ V ; $E_{1/2} = -0{,}97$ V
1-(N-Methylamino)-9-(dimethylamino)-phenaleniumtetrafluorborat $E_{1/2} = -0{,}43$ V ; $E_{1/2} = -1{,}3$ V

Halbwerts- oder Halbstufenpotentiale sind in den gängigen Lehrbüchern der Elektrochemie definiert (vgl. z. B. « Organic Electrochemistry » M. N. Baizer, M. Dekker Verlag, New York, 1973).

Weiterhin ist bekannt, daß die substituierten Phenalene ausgesprochen intensiv gefärbte Verbindungen sind und als Farbstoffe verwendet werden können (vgl. GB-PS 1 388 417).

Bekannte elektrochrome Systeme, wie z. B. das mit Tetrathiafulvalen (TTF) gekoppelte Poly(vinylbenzylchlorid) besitzen den Nachteil, daß die aktiven Gruppen eine relativ schwache Absorption im sichtbaren Bereich besitzen, so daß der gewünschte Effekt nicht sehr stark ausgeprägt ist. Die muß bei der Verwendung dieses und anderer Systeme durch eine Erhöhung der Schichtdicke des Polymeren und/oder der Verwendung großer TTF-Mengen ausgeglichen werden. Dies führt zu erhöhten elektrischen Widerstandswerten und damit zu höheren Ansprechzeiten und verminderter Empfindlichkeit.

Der Erfindung lag daher die Aufgabe zugrunde, neue, einfach darzustellende Polymere mit mindestens zwei stabilen und reversibel ineinander umwandelbaren Oxidationsstufen zu synthetisieren. Die Polymeren sollen mindestens zwei stabile Oxidationsstufen mit Halbwertspotentialen von $E_{1/2} = -1{,}5$ V bis $E_{1/2} = +1{,}0$ V aufweisen. Sie sollen ferner eine starke Absorption im sichtbaren Bereich besitzen. Durch die Eigenschaften der Polymeren sollen insbesondere eine sehr gute, im allgemeinen verbesserte Verwendbarkeit und Anwendungsbreite in der Elektrotechnik und der Chemie gegeben sein.

Diese Aufgabe wird durch die erfindungsgemäßen neuen Polymeren und das Verfahren zu ihrer Herstellung gelöst.

Gegenstand der Erfindung sind danach Polymere, welche mindestens zwei stabile und reversibel ineinander umwandelbare Oxidationsstufen mit Halbwertspotentialen im Bereich von $E_{1/2} = -1{,}5$ V bis + 1 V auszubilden vermögen, enthaltend als Seitengruppe an der Polymerhauptkette 1,9-disubstituierte Phenalenreste die, über die 9-Stellung mit der Polymerhauptkette verknüpft sind.

Die erfindungsgemäßen Polymeren werden erhalten durch Umsetzung von Polymeren mit reaktiven

Gruppen mit 1,9-disubstituierten Phenalenen. Die Umsetzung erfolgt im allgemeinen in Lösungsmitteln bei Temperaturen im Bereich von 50 bis 150 °C. Zur Einstellung des jeweils gewünschten Halbwertspotentials können die erfindungsgemäß hergestellten Polymeren oxidiert bzw. reduziert werden.

Zur Umsetzung mit den Polymeren mit den reaktiven Gruppen sind insbesondere 1,9-disubstituierte Phenalene der allgemeinen Formeln (I) oder (II)

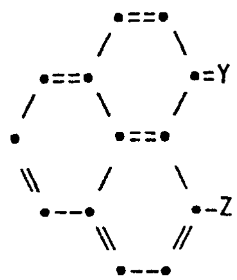 (I) 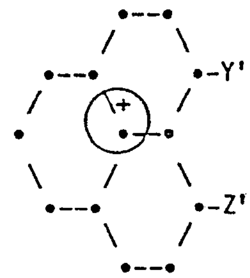 $BF_4^{\ominus}$ (II)

geeignet, worin

Y : O, NR, S, Se oder Te ;

Z : OR, SR, $NR_2$, $-O-(CH_2)_m-OR$, $-NH-(CH_2)_m-OR$, $-S-(CH_2)_m-OR$, $-NH-(CH_2)_m-NR_2$, $-O-(CH_2)_m-NR_2$, $-S-(CH_2)_m-NR_2$, $-O-(CH_2)_m-CHO$ oder $-N_2MeF_6$ mit ME = As oder Sb ;

Y' : —OR, —SR oder $-NR_2$,

Z' : —OR, —SR oder $-NR_2$ ;

R : H, $C_1$-$C_5$-Alkyl, $C_6$-$C_{12}$-Cycloalkyl, $C_7$-$C_{14}$-Aralkyl, wobei in der Gruppe $-NR_2$ die beiden Reste R auch cyclisch miteinander verbunden sein können ;

m : eine Zahl von 1 bis 5.

In den Formeln (I) und (II) ist Y vorzugsweise O, NR oder S und insbesondere O ; Z vorzugsweise OR, $NR_2$, SR, $-O-(CH_2)_m-OR$, $-NH-(CH_2)_m-OR$, $-O-(CH_2)_m-NR_2$, $-NH-(CH_2)_m-NR_2$ oder $-O-(CH_2)_m-CHO$ ; Y' vorzugsweise OR oder $NR_2$ ; Z' vorzugsweise OR oder $NR_2$ und R vorzugsweise H oder $C_1$-$C_5$-Alkyl, wie z. B. Methyl, Ethyl, Butyl. Wenn Z = SR ist, ist R insbesondere $C_1$-$C_5$-Alkyl ; wenn Z = $-NH-(CH_2)_m-OR$, $-NH-(CH_2)_m-NR_2$, $-O-(CH_2)_m-OR$ oder $-O-(CH_2)_m-NR_2$ ist, ist R insbesondere H ; wenn Z = $NR_2$ ist, können die Reste R insbesondere beide H, beide $C_1$-$C_5$-Alkyl oder ein Rest R = H und der zweite Rest R = $C_1$-$C_5$-Alkyl sein. Wenn Y' oder Z' = OR ist, ist R insbesondere $C_1$-$C_5$-Alkyl ; wenn Y' oder Z' = $NR_2$ ist, sind die Reste R insbesondere entweder beide $C_1$-$C_5$-Alkyl, oder über eine Alkylenbrücke cyclisch miteinander verknüft oder einer H und der andere $C_1$-$C_5$-Alkyl.

Geeignete 1,9-substituierte Phenalene sind z. B. 9-n-Butoxy-1-phenalenon, 9-N-Methylamino-1-phenalenon, 9-Amino-1-phenalenon, 9-(Butylthio)-1-phenalenon, 9-Mercapto-1-phenalenon, 9-Mercapto-1-thiophenalenon, 9-Hydroxy-1-thiophenalenon, 9-Amino-1-thiophenalenon, 9-N-Butylamino-1-thiophenalenon, 9-n-Butoxy-1-thiophenalenon, 9-Amino-1-iminophenalenon, 1-(Ethoxy)-9-(benzylthio)phenaleniumtetrafluorborat, 1-(Ethoxy)-9-(butoxy)phenaleniumtetrafluorborat, 1-Ethoxy-9-(ethoxy)phenaleniumtetrafluorborat, 9-(Isopropylamino)-1-(ethoxy)phenaleniumtetrafluorborat, 9-(Dimethylamino)-1-(ethylamino)phenaleniumtetrafluorborat, 9-(Methylamino)-1-(methylamino)phenaleniumtetrafluorborat, 9-(Butoxy)-1-(pyrrolidino)phenaleniumtetrafluorborat, 1-Phenalenon-9-diazoniumhexafluorantimonat oder 1-Thiophenalenon-9-diazoniumhexafluorantiminat. Weiter können genannt werden 9-Butoxy-1-alkyliminophenalenon, 9-(Butoxy)-1-(butylthio)-phenaleniumtetrafluorborat, 9-(Butylthio)-1-(ethoxy)phenaleniumtetrafluorborat, 9-(Pentylenoxy-5'-aldehyd)-1-phenalenon, 9-N-(n-Butylen-4'-ol)amino-1-phenalenon, 9-N(n-Butylen-4'-amin)-amino-phenalenon. Die Darstellung dieser erfindungsgemäß einzusetzenden 1,9-disubstituierten Phenalene ist in den Literaturstellen Journal of Organic Chemistry, *44*, 1704 (1979), Tetrahedron, *34*, 2147 (1978) sowie in der GB-PS 1 388 417 beschrieben.

Als Polymere mit den reaktiven Seitengruppen, die für die Umsetzung mit den 1,9-disubstituierten Phenalenen in Betracht kommen, eignen sich insbesondere solche, die wiederkehrende Einheiten der allgemeinen Formeln (III), (IV) oder (V)

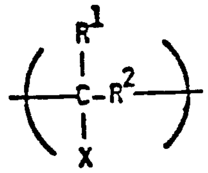 (III) 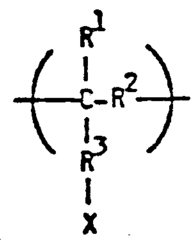 (IV)

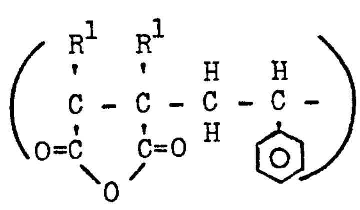 (V)

und gegebenenfalls weitere Comonomere ohne reaktive Gruppen eingebaut enthalten, worin bedeuten

X : OH, SH, $NH_2$, —$COOR^1$, —O—C(O)—$R^4$, COCl oder Halogen ;

$R^1$ : H, $C_1$-$C_5$-Alkyl oder Aryl ;

$R^2$ : $C_1$-$C_5$-Alkylen oder -Alkyliden oder Arylen ;

$R^3$ : $C_1$-$C_5$-Alkylen oder -Alkyliden, 1,4-Cycloalkylen, p-Arylen oder p-Arylalkylen ;

$R^4$ : $C_1$-$C_5$-Alkyl.

Als Halogen in dem Rest X kommen insbesondere Cl oder Br in Betracht. Als Beispiele für den Rest $R^1$ seien genannt Methyl, Ethyl, Propyl, Butyl und Phenyl. $R^2$ kann beispielsweise $CH_2$, $C_2H_4$, $C_3H_6$, $C_4H_8$ oder ein gegebenenfalls substituierter Phenylenrest sein. Beispiele für den Rest $R^3$ sind $CH_2$, $C_2H_4$, $C_3H_6$, $C_4H_8$, $C_6H_{10}$ oder ein gegebenenfalls substituierter Phenylenrest, wie $C_6H_4$ oder 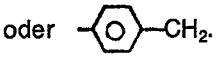. Der Rest $R^4$ ist z. B. Methyl, Ethyl, Propyl oder Butyl. Vorzugsweise sind $R^1$ = H, $CH_3$— oder $C_2H_5$— ; $R^2$ = —$CH_2$— oder —$CH(CH_3)$— ; $R^3$ = —$CH_2$—, —$C_2H_4$—, 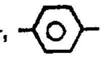 oder 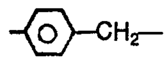 ; $R^4$ = $CH_3$ ; X = OH, $NH_2$, $COOR^1$, —O—C(O)—$R^4$, COCl oder Cl. In dem Rest X = $COOR^1$ ist $R^1$ bevorzugt H, $CH_3$, $C_2H_5$ oder $C_4H_9$.

Bei den Polymeren mit den reaktiven Seitengruppen kann es sich um solche handeln, die allein aus wiederkehrenden Einheiten der allgemeinen Formeln (III), (IV) oder (V) aufgebaut sind. Diese Polymere enthalten im allgemeinen 5 bis 10 000, vorzugsweise 50 bis 5 000, der Einheiten der allgemeinen Formeln (III), (IV) oder (V) eingebaut. Es kann sich aber gleichermaßen auch um Copolymere handeln, die neben den Einheiten beispielsweise der allgemeinen Formeln (III) oder (IV) noch weitere Comonomere ohne reaktive Gruppen, wie z. B. Ethylen, Propylen oder Styrol, eingebaut enthalten. In solchen Copolymeren richtet sich das Verhältnis der comonomeren Bausteine untereinander und damit der Anteil der reaktiven Gruppen im Copolymeren u. a. nach dem gewünschten Grad der Modifizierung mit den 1,9-disubstituierten Phenalenen. Das Molekulargewicht der Polymeren mit den reaktiven Seitengruppen kann in weiten Grenzen schwanken und liegt vorzugsweise im Bereich von 500 bis 1 000 000, insbesondere zwischen 5 000 und 500 000 (Gewichtsmittel).

Geeignete Polymere, die wiederkehrende Einheiten der allgemeinen Formeln (III) oder (IV) eingebaut enthalten, sind beispielsweise : Poly(vinylchlorid), Poly(vinylalkohol), teilverseiftes Polyvinylacetat, Polyvinylacetat oder Poly(vinylamin), ferner Poly(-1-amino-propen-(2)), Poly(1-hydroxy-propen-(2)), Poly(crotonsäuremethylester), Poly(vinylessigsäuremethylester), Poly(vinylessigsäurechlorid), Poly(p-aminostyrol), Poly(p-amino-alpha-methyl-styrol), Poly(p-chlormethylstyrol), Poly(acrylsäure), Poly(acrylsäureethylester), Poly(acrylsäurechlorid), Poly-(methacrylsäure), Poly(methacrylsäuremethylester) sowie Poly(methacrylsäureethylester).

Geeignete Polymere der allgemeinen Formel (III) sind z. B. Copolymere aus Styrol und Fumar- und/oder Maleinsäureanhydrid. Besonders geeignete Polymere sind : Poly(vinylamin), Poly(p-aminostyrol), Poly(vinylalkohol), teilverseiftes Polyvinylacetat, Poly(vinylacetat) oder Copolymere aus Styrol und Maleinsäureanhydrid. Besonders gut geeignet ist Poly(p-aminostyrol).

Zur Herstellung der erfindungsgemäßen Polymeren werden die Polymeren mit den reaktiven Seitengruppen üblicherweise in geeigneten Lösungsmitteln bei 50-150 °C gelöst und die 1,9-disubstituierten Phenalene, in den selben Lösungsmitteln gelöst, in der Hitze zugetropft. Die entstandenen Reaktionsprodukte werden nach 1 bis 30 Stunden durch Zugabe einer geeigneten, die erfindungsgemäßen Polymere nicht lösenden Flüssigkeit ausgefällt und isoliert. Gegebenenfalls löst man das so isolierte erfindungsgemäße Polymere wieder auf und fällt es durch Zugabe der nicht lösenden Flüssigkeit wieder aus. Dieses Umfällen kann mehrmals wiederholt werden.

Geeignete Lösungsmittel für die Herstellung der erfindungsgemäßen Polymeren sind Ethanol, Methanol, Trichlormethan, Dichlormethan, 1,2-Dichlorethan, Dimethylformamid (DMF), N-Methylpyrrolidon, Perchlorbutadien, Dibutylether und Tetrahydrofuran (THF). Besonders geeignet sind DMF, Perchlorbutadien, 1,2-Dichlormethan oder THF. Insbesondere günstig ist THF. Geeignete, die erfindungsgemäßen Polymeren nicht lösende Flüssigkeiten sind z. B. Acetonitril, n-Hexan oder n-Heptan.

Durch die Umsetzung der Polymeren mit den reaktiven Seitengruppen mit den 1,9-disubstituierten Phenalenen erhält man polymere organische Substanzen, welche 1,9-disubstituierte Phenalene als Seitengruppe an den Polymerhauptketten tragen, wobei die Verknüpfung zwischen den Polymerhauptketten und den Phenalenresten über die 9-Stellung am Phenalenrest erfolgt. Diese erfindungsgemäßen Polymeren vermögen mindestens zwei stabile und reversibel ineinander umwandelbare Oxidationsstufen auszubilden.

Zur Änderung der Oxidationsstufen werden die erfindungsgemäßen Polymeren oxidiert bzw. reduziert. Die Oxidation oder Reduktion geschieht dabei vorzugsweise elektrochemisch, in dem z. B. die erfindungsgemäßen Polymeren durch « spin-coating » auf Elektrodenplättchen als 1 bis 1 000 µm dicke Filme aufgebracht und in dieser Form elektrochemisch oxidiert oder reduziert werden.

Im folgenden wird eine Übersicht über ausgewählte erfindungsgemäße Reaktionen gegeben. Besonders bevorzugte erfindungsgemäße Polymere werden erhalten bei der Umsetzung von Poly(p-aminostyrol) mit 9-Butoxy-1-phenalenon oder mit 9-(Butoxy)-1-(ethoxy)phenaleniumtetrafluorborat. Als Beispiel für die Änderung der Oxidationsstufe in den erfindungsgemäßen Polymeren und damit deren Halbwertspotentiel ist die Reaktion von Poly[p-N-(9'-phenalen-1'-on)aminostyrol)] mit Triethyloxoniumtetrafluorborat angeführt.

Die neuen Polymeren können in der Elektrotechnik zur Herstellung elektrisch leitfähiger Systeme, zur Umwandlung und Fixierung von Strahlung, zur Herstellung elektrischer Schalter, als « elektrochromic displays », zur antistatischen Ausrüstung von Kunststoffen oder als reversible Redoxsysteme verwendet werden.

Übersicht über die Reaktionsschemata

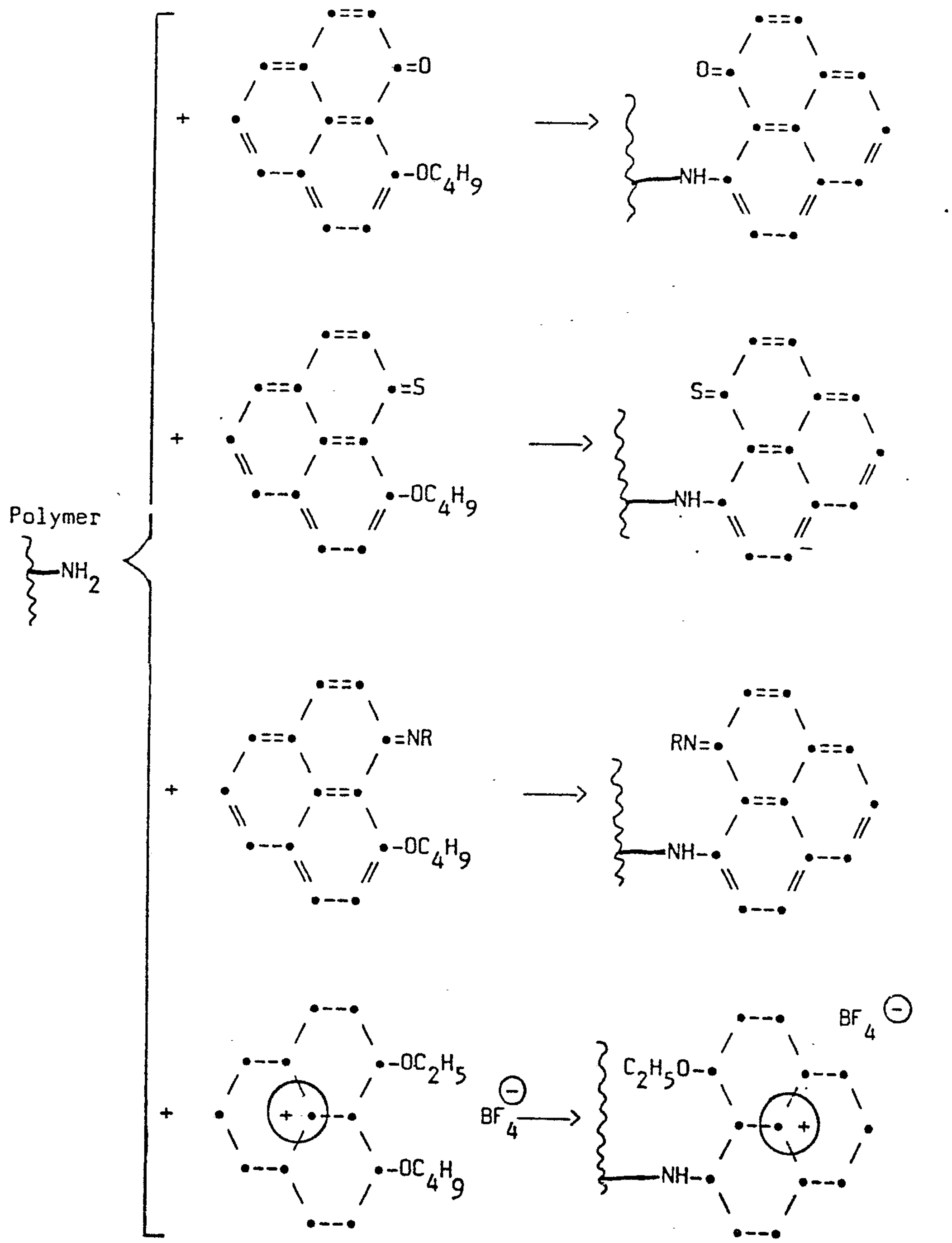

Reaktionsschemata (Fortsetzung)

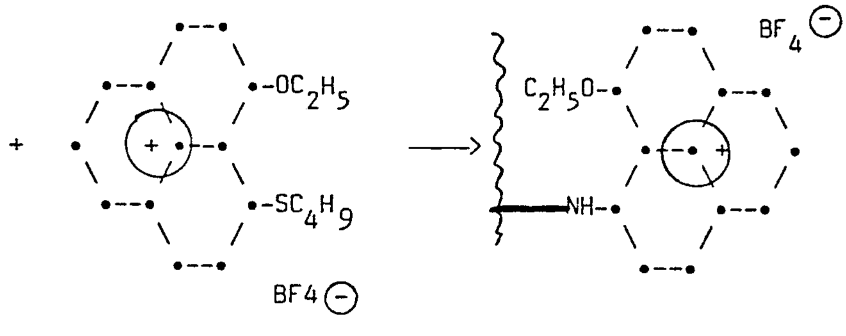

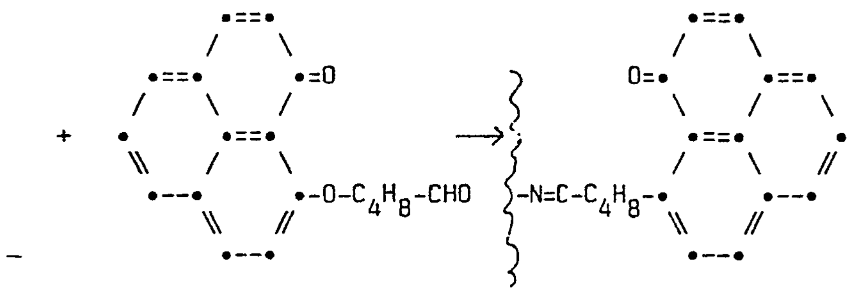

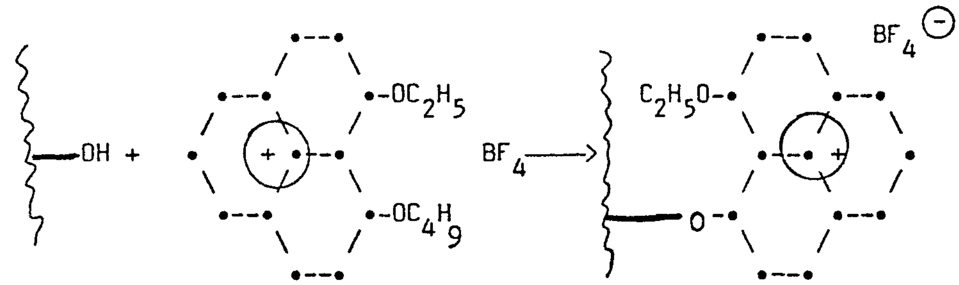

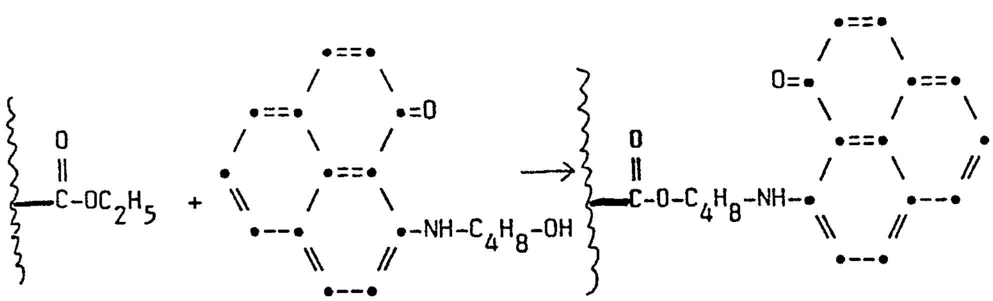

Reaktionsschemata (Fortsetzung)

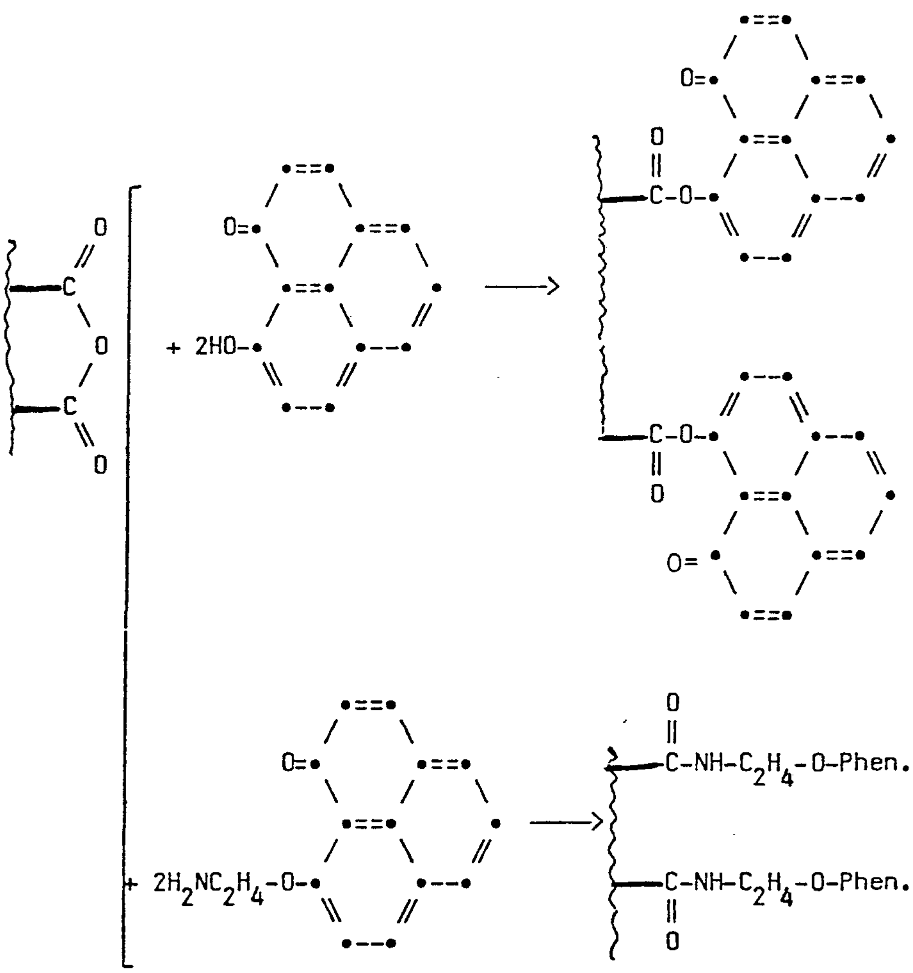

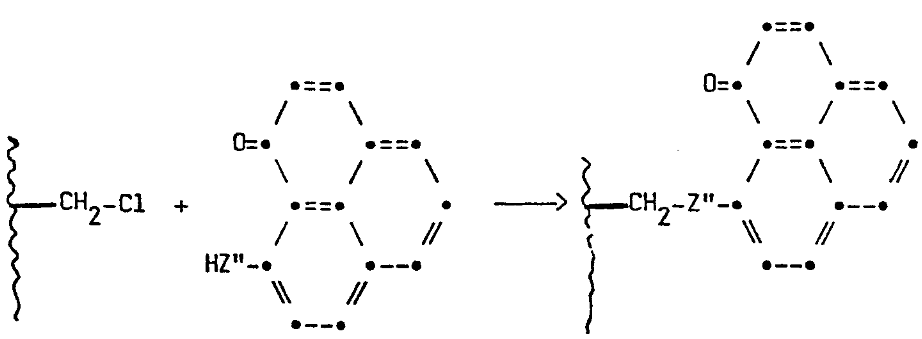

(Z" = -O-, -S-, -NR-)

Reaktionsschemata (Fortsetzung)

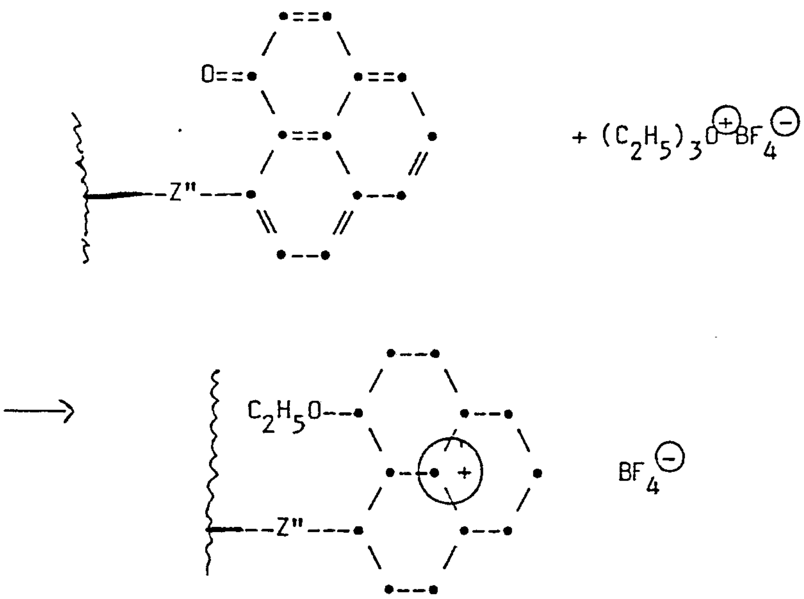


(Z" = -O-, -S-, -NR-)

Beispiel 1

1 Mol Poly(p-aminostyrol) (= 119 g) werden in 1 500 ml Tetrahydrofuran (THF) gelöst und auf 65 °C erhitzt. 1 Mol (= 252 g) 9-Butoxy-1-phenalenon werden in 250 ml THF gelöst und zur heißen Polymerlösung im Lauf von 30 Minuten unter Rühren zugetropft. Man läßt 10 Stunden bei 65 °C nachreagieren und fällt dann das Polymere durch Zutropfen von 1 000 ml n-Hexan aus. Das ausgefallene Produkt wird abgenutscht und noch zweimal mit THF/n-Hexan umgefällt.

Ausbeute an Poly[p-N-(9'-phenalen-1'-on)aminostyrol] : 279 g Derivatisierungsgrad ca. 90 %, bezogen auf Poly(p-amino-styrol).

Formel

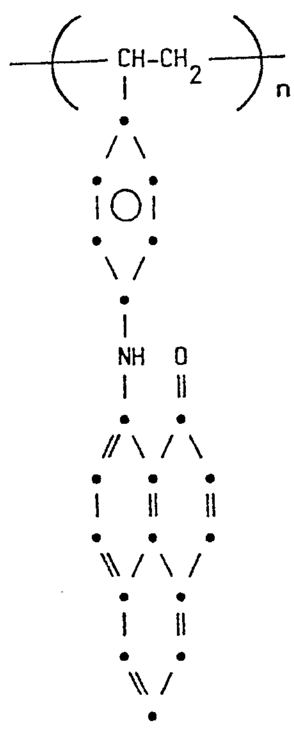

Redoxverhalten, Beispiel 1

Das mit 9-Butoxy-1-phenalenon umgesetzte Poly(p-amino-styrol) (Beispiel 1) wird in Tetrahydrofuran gelöst und durch « spin coating » auf platinbeschichtete Silikonplättchen in einer Schichtdicke von 1 bis 1 000 μm aufgebracht. Ein solches beschichtetes Plättchen wird in ein Bad von Acetonitril, in dem Tri-n-butylammoniumperchlorat als Leitsalz aufgelöst ist, eingetaucht. Das Oxidations- und Reduktionsverhalten der Beschichtung wird nun gegen eine Silberchloridelektrode durch cyclische Voltametrie gemessen. Folgende Halwertspotentiale ($E_{1/2}$) wurden gemessen :

$E_{1/2}$ = ca. − 1,3 V ; Farbumschlag : Rot → Braun

Beispiel 2

1 Mol Poly(p-aminostyrol) (= 119 g) werden in 1 000 ml 1,2-Dichlorethan gelöst und auf 50 °C erhitzt. 1 Mol (= 368 g) 9-n-Butoxy-1-(ethoxy)phenaleniumtetrafluorborat werden in 1 000 ml 1,2-Dichlorethan gelöst und im Laufe von 1 Stunde zur Polymerlösung unter Rühren zugetropft. Man läßt 10 Stunden bei 80 °C nachreagieren und engt anschließend die Lösung im Vakuum auf 500 ml ein. Durch Zusatz von 1 000 ml n-Heptan wird das derivatisierte Polymere ausgefällt und durch Filtration abgetrennt. Das Produkt wird im Vakuum getrocknet.

Ausbeute an Poly{p-N[9'-phenalenium-1'-(ethoxy)tetrafluorborat]aminostyrol} : 413 g = 100 %.

Derivatisierungsgrad ca. 100 %, bezogen auf Poly(p-aminostyrol)

Formel

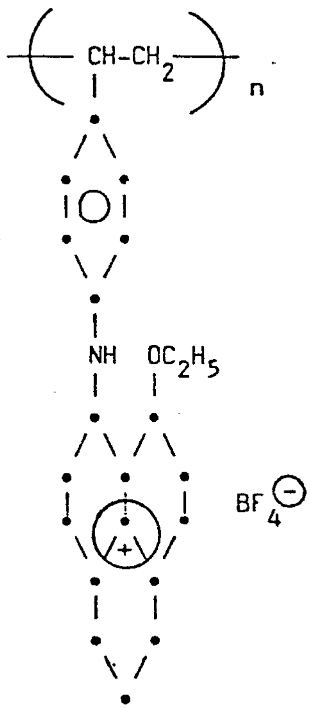

Redoxverhalten, Beispiel 2

Das erfindungsgemäße Polymere wird, wie in Beispiel 1 beschrieben, als Film in einer Dicke von 1 bis 1 000 μm auf platinbeschichtete Silikonplättchen aufgebracht und in einer Acetonitril/Tri-n-butylammoniumperchloratlösung durch cyclische Voltametrie untersucht (Vergleich : Silberchloridelektrode). Folgende Halbwertspotentiale wurden gemessen :

$E_{1/2}$ = − 0,3 V ; Farbumschlag : Tiefgrün → Braun

$E_{1/2}$ = − 1,4 V ; Farbumschlag : Braun → Blau

Beispiel 3

0,2 Mol Poly[p-N-(9'-phenalen-1'-on)aminostyrol] (= 59,2 g) werden in 300 ml Perchlorbutadien gelöst. Zu dieser Lösung wird bei Zimmertemperatur unter Rühren eine Lösung von 0,2 Mol Triethyloxoniumtetrafluorborat (= 38 g) in Perchlorbutadien (200 ml) im Laufe von 1 Stunde zugetropft. Man läßt 5 Stunden nachreagieren und fällt anschließend das Produkt aus der auf 200 ml eingeengten Lösung durch Zugabe von n-Heptan aus. Das Produkt wird durch zweimaliges Umfällen mit Perchlorbutadien/n-Hexan gereinigt.

Ausbeute am Poly{p-N-[9'-phenalenium-1'-(ethoxy)tetrafluorborat]aminostyrol} (Formel siehe Beispiel 2) : 82 g = 99 %.

Ethoxylierungsgrad ca. 100 %.

Redoxverhalten, Beispiel 3

Das Redoxverhalten des Polymeren war identisch mit dem aus Beispiel 2. Es wurden folgende Halbwertspoteniale ($E_{1/2}$) gemessen :

$E_{1/2} = -0,26$ V ; Farbumschlag : Tiefgrün → Braun

$E_{1/2} = -1,39$ V ; Farbumschlag : Braun → Blau

**Patentansprüche**

1. Polymeres, welches mindestens zwei stabile und reversibel ineinander umwandelbare Oxidationsstufen mit Halbwertspotentialen im Bereich von $E_{1/2} = -1,5$ bis $+1$ V auszubilden vermag, enthaltend als Seitengruppe an der Polymerhauptkette 1,9-disubstituierte Phenalenreste, wobei die Verbindungen zwischen der Polymerhauptkette und den Phenalenresten über die 9-Stellung am Phenalenrest erfolgt.

2. Polymeres gemäß Anspruch 1, erhalten durch Umsetzung eines Polymeren mit reaktiven Seitengruppen mit einem 1,9-disubstituierten Phenalen der allgemeinen Formeln (I) oder (II)

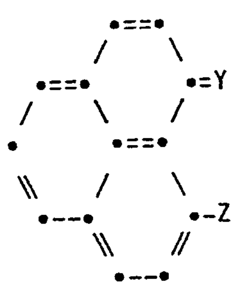 (I) 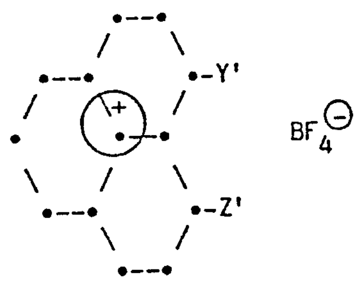 (II)

worin bedeuten

Y : O, NR, S, Se oder TE ;

Z : OR, SR, $NR_2$, $-O-(CH_2)_m-OR$, $-NH-(CH_2)_m-OR$, $-S-(CH_2)_m-OR$, $-NH-(CH_2)_m-NR_2$, $-O-(CH_2)_m-NR_2$, $-S-(CH_2)_m-NR_2$, $-O-(CH_2)_m-CHO$ oder $-N_2MeF_6$ mit Me = As oder Sb ;

Y' : —OR, —SR oder $-NR_2$,

Z' : —OR, —SR oder $-NR_2$ ;

R : H, $C_1$-$C_5$-Alkyl, $C_6$-$C_{12}$-Cycloalkyl, $C_7$-$C_{14}$-Aralkyl, wobei in der Gruppe $-NR_2$ die beiden Reste R auch cyclisch miteinander verbunden sein können ;

m : eine Zahl von 1 bis 5.

3. Polymeres gemäß Anspruch 2, erhalten durch Umsetzung von 1,9-disubstituierten Phenalenen der allgemeinen Formeln (I) oder (II) mit einem Polymeren, das wiederkehrende Einheiten der allgemeinen Formeln (III), (IV) oder (V)

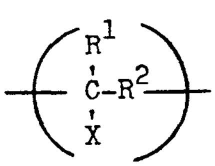 (III) 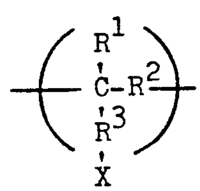 (IV)

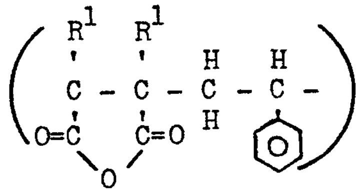 (V)

und gegebenenfalls weitere Comonomere ohne reaktive Gruppen eingebaut enthält, worin bedeuten

X : OH, SH, $NH_2$, $-COOR^1$, $-O-C(O)-R^4$, COCl oder Halogen ;

$R^1$ : H, $C_1$-$C_5$-Alkyl oder Aryl ;

$R^2$ : $C_1$-$C_5$-Alkylen oder -Alkyliden oder Arylen ;
$R^3$ : $C_1$-$C_5$-Alkylen oder -Alkyliden, 1,4-Cycloalkylen, p-Arylen oder p-Alkylarylen
$R^4$ : $C_1$-$C_5$-Alkyl.

4. Polymeres gemäß Anspruch 3, worin das der Umsetzung zugrundeliegende Polymere 5 bis 10 000 Einheiten der allgemeinen Formeln (III), (IV) oder (V) eingebaut enthält.

5. Polymeres nach Anspruch 2, worin
Y : O, S oder NR ;
Z : OR, SR, $NR_2$, $-O-(CH_2)_m-OH$, $-NH-(CH_2)_m-OH$, $-NH-(CH_2)_m-NH_2$, $-O-(CH_2)_m-NH_2$ oder $-O-(CH_2)_m-CHO$ ;
Y' : —OR oder $-NR_2$
Z' : —OR oder $-NR_2$
ist.

6. Polymeres nach Anspruch 3, worin das der Umsetzung zugrundeliegende Polymer wiederkehrende Einheiten der allgemeinen Formeln (III) oder (IV) eingebaut enthält, worin
$R^1$ : H oder $C_1$-$C_5$-Alkyl,
$R^2$ : $C_1$-$C_5$-Alkylen oder -Alkyliden und
$R^3$ : $C_1$-$C_5$-Alkylen oder -Alkyliden, 1,4-Cyclohexylen, p-Phenylen oder 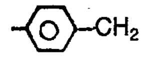 bedeuten und
X die im Anspruch 3 angegebene Bedeutung besitzt.

7. Polymeres nach Anspruch 3, worin das der Umsetzung zugrundeliegende Polymer ein Copolymerisat aus Styrol und Maleinsäureanhydrid und/oder Fumarsäureanhydrid ist.

8. Verfahren zur Herstellung von Polymeren mit mindestens zwei stabilen und reversibel umwandelbaren Oxidationsstufen mit Halbwertspotentialen im Bereich von $E_{1/2} = -1{,}5$ bis $+1$ V, dadurch gekennzeichnet, daß man Polymere mit reaktiven Seitengruppen mit 1,9-disubstituierten Phenalenen der allgemeinen Formeln (I) oder (II)

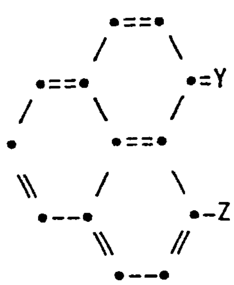 (I) 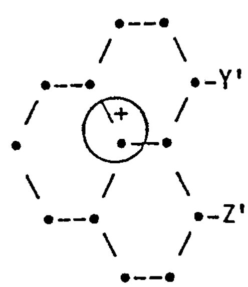 $BF_4^{\ominus}$ (II)

umsetzt.

9. Verfahren nach Anspruch 8, dadurch gekennzeichnet, daß die Polymeren mit reaktiven Seitengruppen wiederkehrende Einheiten der allgemeinen Formeln (III), (IV) oder (V) und gegebenenfalls weitere Comonomere ohne reaktive Gruppen eingebaut enthalten.

10. Verfahren nach Anspruch 8 oder 9, dadurch gekennzeichnet, daß die Umsetzung in Lösungsmitteln bei Temperaturen von 50 bis 150 °C durchgeführt wird.

11. Verfahren nach Ansprüchen 8 bis 10, dadurch gekennzeichnet, daß die erhaltenen Polymeren anschließend reduziert oder oxidiert werden.

12. Verwendung der Polymeren nach Anspruch 1 in der Elektrotechnik zur Herstellung elektrisch leitfähiger Systeme, zur Umwandlung und Fixierung von Strahlung, zur Herstellung elektrischer Schalter sowie als « elektrochromic displays ».

13. Verwendung der Polymeren nach Anspruch 1 zur antistatischen Ausrüstung von Kunststoffen.

14. Verwendung der Polymeren nach Anspruch 1 als reversible Redoxsysteme.

**Claims**

1. A polymer which is capable of forming at least two stable, reversibly interconvertible oxidation states with halfwave potentials $E_{1/2}$ of from $-1.5$ to $+1$ V, and contains, as a side group, a 1,9-disubstituted phenalene radical linked to the main polymer chain via the 9-position of the phenylene radical.

2. A polymer as claimed in claim 1, obtained by reacting a polymer having a reactive side group with a 1,9-disubstituted phenalene of the general formula (I) or (II)

(See Figures page 12)

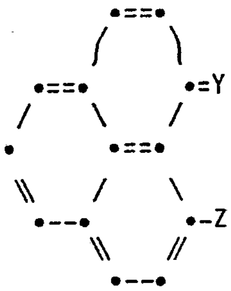 (I) 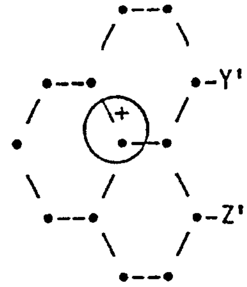 $BF_4^{\ominus}$ (II)

where

Y is O, NR, S, SE or TE,

Z is OR, SR, $NR_2$, $—O—(CH_2)_m—OR$, $—NH—(CH_2)_m—OR$, $—S—(CH_2)_m—OR$, $—NH—(CH_2)_m—NR_2$, $—O—(CH_2)_m—NR_2$, $—S—(CH_2)_m—NR_2$, $—O—(CH_2)_m—CHO$ or $—N_2MeF_6$ where Me is As or Sb, and

Y' is —OR, —SR or $—NR_2$,

Z' is —OR, —SR or $—NR_2$, and

R is H, $C_1$-$C_5$-alkyl, $C_6$-$C_{12}$-cycloalkyl or $C_7$-$C_{14}$-aralkyl, and, in the group $—NR_2$, the two radicals R may also be cyclically linked to one another, and

m is 1-5.

3. A polymer as claimed in claim 2, obtained by reacting a 1,9-disubstituted phenalene of the formula (I) or (II) with a polymer containing repeating units of the general formula (III), (IV) or (V)

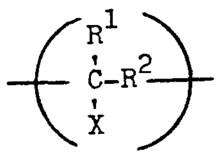 (III) 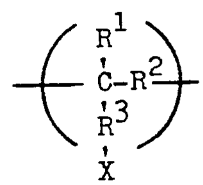 (IV)

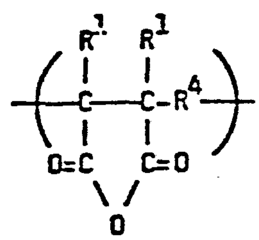 (V)

where

X is OH, SH, $NH_2$, $—COOR^1$, $—O—C(O)—R^5$, COCl or halogen,

$R^1$ is H, $C_1$-$C_5$-alkyl or aryl,

$R^2$ is $C_1$-$C_5$-alkylene, $C_1$-$C_5$-alkylidene or arylene,

$R^3$ is $C_1$-$C_5$-alkylene, $C_1$-$C_5$-alkylidene, 1,4-cycloalkylene, p-arylene or p-alkylarylene, and

$R^4$ is $C_1$-$C_5$-alkyl, and optionally containing further comonomers without reactive groups.

4. A polymer as claimed in claim 3, wherein the polymer reacted with 1,9-disubstituted phenalene contains from 5 to 10,000 units of the general formula (III), (IV) or (V).

5. A polymer as claimed in claim 2, where

Y is O, S or NR,

Z is OR, SR, $NR_2$, $—O—(CH_2)_m—OH$, $—NH—(CH_2)_m—OH$, $—NH—(CH_2)_m—NH_2$, $—O—(CH_2)_m—NH_2$ or $—O—(CH_2)_m—CHO$,

Y' is —OR or $—NR_2$, and

Z' is —OR or $—NR_2$.

6. A polymer as claimed in claim 3, wherein the polymer reacted with 1,9-disubstituted phenalene contains repeating units of the general formula (III) or (IV), where

$R^1$ is H or $C_1$-$C_5$-alkyl,

$R^2$ is $C_1$-$C_5$-alkylene or $C_1$-$C_5$-alkylidene,

$R^3$ is $C_1$-$C_5$-alkylene, $C_1$-$C_5$-alkylidene, cyclohexylene, p-phenylene or 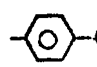$-CH_2$, and

X has the meanings given in claim 3.

7. A polymer as claimed in claim 3, wherein the polymer reacted with 1,9-disubstituted phenalene is a copolymer of styrene and maleic anhydride and/or fumaric anhydride.

8. A process for the preparation of a polymer having at least two stable, reversibly interconvertible

oxidation states with half-wave potentials $E_{1/2}$ of from $-1.5$ to $+1$ V, wherein a polymer having a reactive side group is reacted with a 1,9-disubstituted phenalene of the general formula (I) or (II)

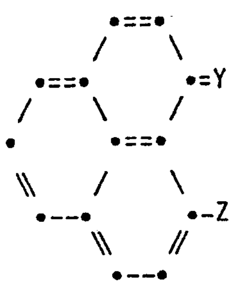 (I) 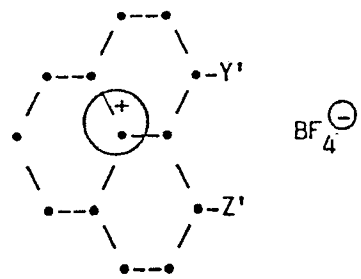 (II)

9. A process as claimed in claim 8, wherein the polymer having a reactive side group contains repeating units of the general formula (III), (IV) or (V) and, if desired, further comonomers without reactive groups.

10. A process as claimed in claim 8 or 9, wherein the reaction is carried out in a solvent at from 50 to 150 °C.

11. A process as claimed in claims 8 to 10, wherein the polymer obtained is subsequently reduced or oxidized.

12. The use of a polymer as claimed in claim 1 in electrical engineering for the production of electrically conductive systems, for the conversion and fixation of radiation, and for the production of electric switches, and as an electrochromic display.

13. The use of a polymer as claimed in claim 1 for the antistatic finishing of plastics.

14. The use of a polymer as claimed in claim 1 as a reversible redox system.

**Revendications**

1. Polymère, pouvant former au moins deux stades d'oxydation stables et interchangeables de façon réversible, possédant des potentiels de demi-valeur E1/2 dans la gamme de $-1{,}5$ à $+1$ V et contenant comme groupe latéral sur la chaîne polymère principale des groupes phénalène 1,9-disubstitué, les liaisons entre la chaîne polymère principale et les groupes phénalène se faisant sur la position 9 du groupe phénalène.

2. Polymère suivant la revendication 1, obtenu par la réaction d'un polymère à groupes latéraux réactifs avec un phénalène 1,9-disubstitué de l'une des formules générales (I) et (II)

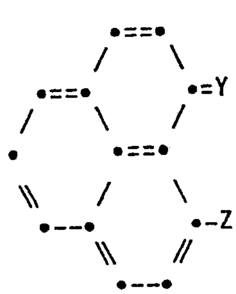 (I) 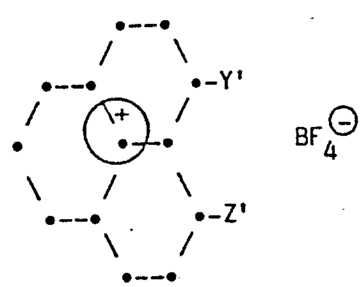 (II)

dans lesquelles

Y = O, NR, S, Se ou Te ;

Z = OR, SR, $NR_2$, $-O-(CH_2)_m-OR$, $-NH-(CH_2)_m-OR$, $-S-(CH_2)_m-OR$, $-NH-(CH_2)_m-NR_2$, $-O-(CH_2)_m-NR_2$, $-S-(CH_2)_m-NR_2$, $-O-(CH_2)_m-CHO$ ou $N_2MeF_6$, où Me = As ou Sb ;

Y' = $-OR$, $-SR$ ou $-NR_2$ ;

Z' = $-OR$, $-SR$ ou $-NR_2$ ;

R = H, alkyle en $C_1$ à $C_5$, cycloalkyle en $C_6$ à $C_{12}$ ou aralkyle en $C_7$ à $C_{14}$, les deux groupes R de $-NR_2$ pouvant former un noyau cyclique, et

m = un nombre entier valant de 1 à 5.

3. Polymère suivant la revendication 2, obtenu par la réaction de phénalènes 1,9-disubstitués de l'une des formules générales (I) et (II) avec un polymère comprenant des unités récurrentes des formules générales (III), (IV) ou (V)

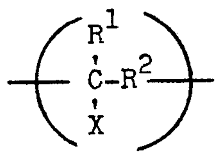 (III) 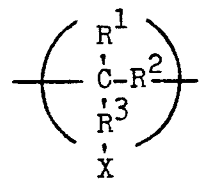 (IV)

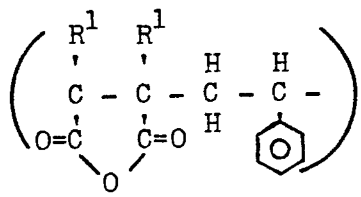 (V)

dans lesquelles

X = OH, SH, $NH_2$, $—COOR^1$, $—O—C(O)—R^4$, COCl ou halogène ;

$R^1$ = H, alkyle en $C_1$ à $C_5$ ou aryle ;

$R^2$ = alkylène ou alkylidène en $C_1$ à $C_5$ ou arylène ;

$R^3$ = alkylène ou alkylidène en $C_1$ à $C_5$, 1,4-cycloalkylène, p-arylène ou p-alkyl-arylène et

$R^4$ = alkyle en $C_1$ à $C_5$,

ainsi qu'éventuellement d'autres comonomères sans groupes réactifs.

4. Polymère suivant la revendication 3, dans lequel le polymère à la base de la réaction contient entre 5 et 10 000 unités des formules générales (III), (IV) et (V).

5. Polymère suivant la revendication 2, dans lequel

Y = O, S ou NR ;

Z = OR, SR, $NR_2$, $—O—(CH_2)_m—OH$, $—NH—(CH_2)_m—OH$, $—NH—(CH_2)_m—NH_2$, $—O—(CH_2)_m—NH_2$ ou $—O—(CH_2)_m—CHO$ ;

Y' = — OR ou $—NH_2$ et

Z' = — OR ou $—NH_2$.

6. Polymère suivant la revendication 3, dans lequel le polymère à la base de la réaction contient des unités récurrentes de la formule générale (III) ou (IV), dans lesquelles

$R^1$ = H ou alkyle en $C_1$ à $C_5$ ;

$R^2$ = alkylène ou alkylidène en $C_1$ à $C_5$ ;

$R^3$ = alkylène ou alkylidène en $C_1$ à $C_5$, 1,4-cyclohexylène, p-phénylène ou 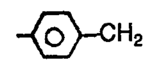$—CH_2$ et

X possède la signification définie dans la revendication 3.

7. Polymère suivant la revendication 3, dans lequel le polymère à la base de la réaction est un copolymérisat du styrène et de l'anhydride maléique et(ou) de l'anhydride fumarique.

8. Procédé de préparation de polymères avec au moins deux stades d'oxydation stables et interchangeables de façon réversible et des potentiels de demi-valeur E1/2 de − 1,5 à + 1 V, caractérisé en ce que l'on fait réagir des polymères avec des groupes latéraux réactifs avec des phénalènes 1,9-disubstitués de l'une des formules générales (I) et (II)

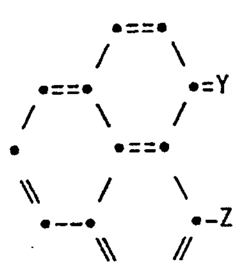 (I) 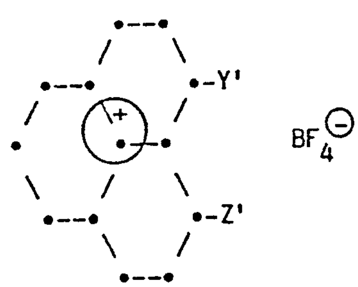 (II)

9. Procédé suivant la revendication 8, caractérisé en ce que les polymères à groupes latéraux réactifs contiennent des unités récurrentes des formules générales (III), (IV) ou (V), ainsi qu'éventuellement d'autres comonomères sans groupes réactifs copolymérisés.

10. Procédé suivant la revendication 8 ou la revendication 9, caractérisé en ce que la réaction est réalisée dans un solvant à des températures comprises entre 50 et 150 °C.

11. Procédé suivant les revendications 8 à 10, caractérisé en ce que les polymères produits sont soumis à une réduction ou une oxydation.

12. Utilisation de polymères suivant la revendication 1 dans le domaine électro-technique pour la

fabrication de systèmes conducteurs de l'électricité, pour la transformation et la fixation de radiations et pour la fabrication de commutateurs électriques et de dispositifs d'affichage (electrochromic displays).

13. Utilisation de polymères suivant la revendication 1 pour l'apprêtage antistatique de matières plastiques.

14. Utilisation de polymères suivant la revendication 1 comme systèmes redox réversibles.